Europäisches Patentamt

European Patent Office

Office européen des brevets

(19)

(11) Publication number: **0 158 749**

A1

# EUROPEAN PATENT APPLICATION

(12)

(21) Application number: 84308970.7

(22) Date of filing: 20.12.84

(51) Int. Cl.⁴: **H 01 L 23/48**

(30) Priority: 17.01.84 JP 6664/84

(43) Date of publication of application:
23.10.85 Bulletin 85/43

(84) Designated Contracting States:
CH DE LI SE

(71) Applicant· MITSUBISHI DENKI KABUSHIKI KAISHA
2-3, Marunouchi 2-chome Chiyoda-ku
Tokyo 100(JP)

(72) Inventor: Hagino, Hiroyasu c/o Mitsubishi Denki K. K.
Kitaitami Seisakusho 1 Mizuhara 4-chome
Itami-shi Hyogo-ken(JP)

(74) Representative: Wright, Peter David John et al,
R.G.C. Jenkins & Co. 12-15, Fetter Lane
London EC4A 1PL(GB)

(54) Semiconducteur device having pressure loaded members.

(57) A semiconductor device comprises a semiconductor chip (13) of pnpn four-layer structure, cathode electrodes (12a and 12b), a gate electrode (11), cathode electrode plates (16a and 16b), a gate electrode plate (15), a ceramic ring (17), a gate electrode external terminal (18), a copper cathode block (19) having a concave portion, and a coned disc spring (23) with plain washers at both ends thereof provided in the concave portion The copper cathode block (19) is in contact with the cathode electrode plates (16a and 16b) by pressure in a manner that the plain washers (22) and the coned disc springs (23) push the ceramic ring (17) downward. The elasticity of the coned disc spring (23) serves to compensate for the tolerance in the size of the gate electrode plate (15) or the ceramic ring (17), whereby the contact by pressure between the gate electrode (11) and the gate electrode plate (15) is made correctly.

FIG. 5

TITLE OF THE INVENTION

Semiconductor Device

BACKGROUND OF THE INVENTION

Field of the Invention

The present invention relates to a semiconductor device and particularly to an improvement of a semiconductor device in which at least one main electrode and at least one control electrode are provided on one surface of a semiconductor substrate.

Description of the Prior Art

As a typical semiconductor device in which at least one main electrode and at least one control electrode are provided on one surface of a semiconductor substrate, a gate turn-off thyristor (GTO) is known in the art. In the following, a conventional GTO will be described.

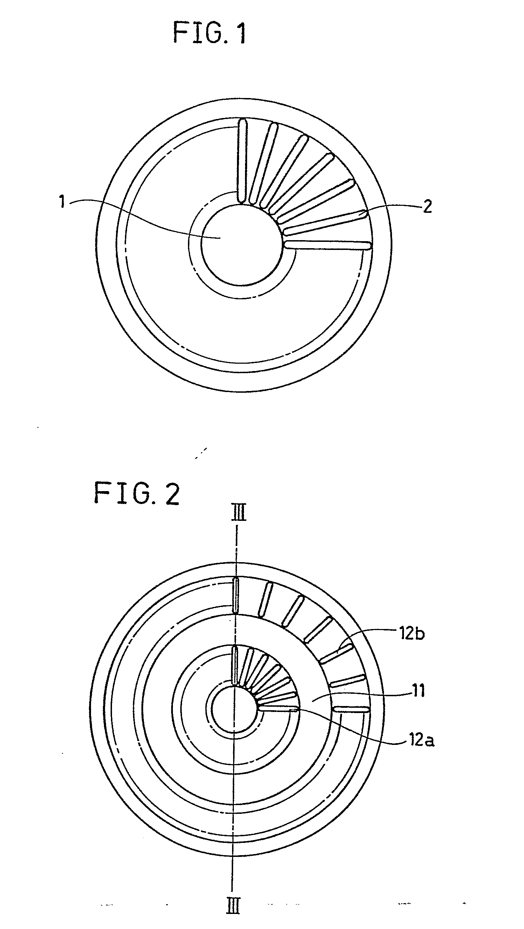

Fig. 1 is a plan view showing a major surface on the cathode side of a conventional GTO wafer having small current capacity. This GTO comprises a gate electrode 1 as a control electrode and a cathode electrode 2 as a main electrode formed in emitter islands. In case where a GTO has small current capacity, a gate electrode 1 is generally provided in the center of a major surface on the cathode side, as shown in Fig. 1. However, the recent tendency to increase the current capacity of a GTO has required improvement in the uniformity of the distance from a gate electrode 1 to each emitter island.

Fig. 2 is a plan view of the cathode side of a GTO wafer having large current capacity disclosed in the Japanese Patent Laying Open Number 62562/1982 where improvement is made in the uniformity of such distance. This GTO comprises cathode electrodes 12a and 12b in emitter islands respectively provided radially to form coaxial multiple rings, as well as a gate electrode 11 provided in a region between the cathode electrodes 12a and 12b. With such structure, the uniformity of the distance from the gate electrode 11 to each emitter island is improved and it is made possible to enlarge the current capacity of a GTO.

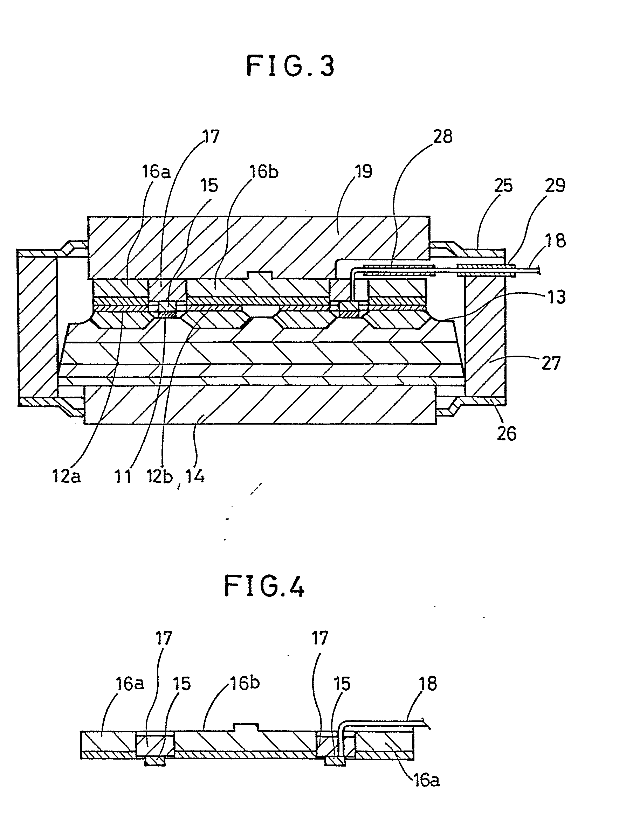

Fig. 3 is a sectional view taken along the line III - III in the conventional GTO shown in Fig. 2. In Fig. 3, a gate electrode 11 and cathode electrodes 12a and 12b are formed on a GTO chip 13 of pnpn four-layer structure by aluminum evaporation. On the other surface of the GTO chip 13, an anode electrode plate 14 in copper is provided. In addition, an assembly comprises a silver gate electrode plate 15 in the form of a ring; cathode electrode plates 16a and 16b each comprising a copper base and a molybdenum layer integrally formed on the lower surface thereof; a ceramic ring 17 brazed on the gate electrode plate 15 to maintain the insulation between the gate electrode plate 15 and the cathode electrode plates 16a and 16b; and an outgoing lead 18 for a silver gate electrode, fixed on the gate electrode plate 11 as by brazing. This assembly is pushed against the GTO chip 13 by a copper cathode block 19, so that the gate electrode 11 is in contact with the corresponding gate electrode plate 15 and the cathode electrodes 12a and 12b are respectively in contact with the corresponding cathode electrode plates 16a and 16b by pressure. Frames 25 and 26 of alloy of iron and nickel have the ends brazed respectively to the cathode block 19 and the anode electrode plate 14 and the other ends brazed respectively to the ceramic cylinder 27. The lead 18 is drawn out to the exterior through a Teflon sleeve provided in the concave portion of the cathode block 19 and a spacer penetrating the cylinder 27.

In such a conventional type, irregularities or tolerance in the size of the components such as the gate electrode plate 15 and the ceramic ring 17. (approximatey $\pm 10$ to $100\,\mu$ in the ordinary manufacturing process) cannot be avoided, and as a result, the upper surfaces of the cathode electrode plates 16a and 16b and the upper surface of the ceramic ring 17 might not be aligned on the same plane.

- 4 -

0158749

Fig. 4 shows the above described assembly comprising the gate electrode plate 15, the cathode electrode plates 16a and 16b, the ceramic ring 17 and the lead 18. Particularly, Fig. 4 shows the case where the upper surface of the ceramic ring 17 is lower than the upper surfaces of the cathode electrode plates 16a and 16b. In such a case, the cathode block 19 cannot push the upper surface of the ceramic ring 17 downward and accordingly the contact by pressure between the gate electrode plate 15 and the gate electrode 11 is made insufficiently. On the other hand, contrary to the case shown in Fig. 4, in case where the upper surface of the ceramic ring 17 protrudes from the upper surfaces of the cathode electrode plates 16a and 16b, pushing by the cathode block 19 would cause damage to the ceramic ring 17, resulting in the deterioration of the electrically insulating function.

SUMMARY OF THE INVENTION

Briefly stated, the present invention is a semiconductor device comprising: a semiconductor substrate; at lease one control electrode formed on one surface of the semiconductor substrate; at least one main electrode formed on a surface of the semiconductor substrate so as to surround the control electrode; a control electrode plate in contact with the control elelectrode by pressure; an insulating plate fixed on the control electrode plate; a main electrode plate in contact with the main electrode by pressure; and a metallic block having a concave portion in the surface thereof containing a spring member, the metallic block serving to push the insulating plate and the main electrode plate downward. According to the present invention, the metallic block is disposed so that the concave portion may be positioned on either the insulating plate or the main electrode plate. In this state, the spring member provided in the concave portion pushes down the portion positioned thereunder and accordingly, the level difference between the upper surface of the main electrode plate and the upper surface of the insulating plate due to the irregulatities of the size of the components can be absorbed by the spring member.

Therefore, a principal object of the present invention is to provide a semiconductor device in which the contact by pressure between an electrode and electrode plate is made correctly.

A principal advantage of the present invention is that since a concave portion in a main electrode plate or an insulating plate is pushed downward by a spring member, the contact by pressure between the electrode and the electrode plate positioned under the concave portion can be made correctly.

Another advantage of the present invention is that since the level difference in a protruding portion in the main electrode plate or the insulating plate is absorbed by the spring member, the protruding portion can be protected from being broken at the time of pushing.

These objects and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a plan view of a major surface on the cathode side of a conventional GTO chip having small current capacity;

Fig. 2 is a plan view of a major surface on the cathode side of a conventional GTO chip of large current capacity provided with an intermediate control electrode;

Fig. 3 is a sectional view taken along the line III - III in the GTO chip shown in Fig. 2;

Fig. 4 is a view showing a state where a level difference is caused between the upper surface of a main electrode plate and the upper surface of an insulating plate shown in Fig. 3;

Fig 5 is a sectional view showing an embodiment of the present invention;

Fig. 6 is a sectional view of coned disc spring shown in Fig. 5; and

Fig. 7 is a weighting characteristic diagram of a coned disc spring shown in Fig. 6.

DESCRIPTION OF THE PREFERRED EMBODIMENT

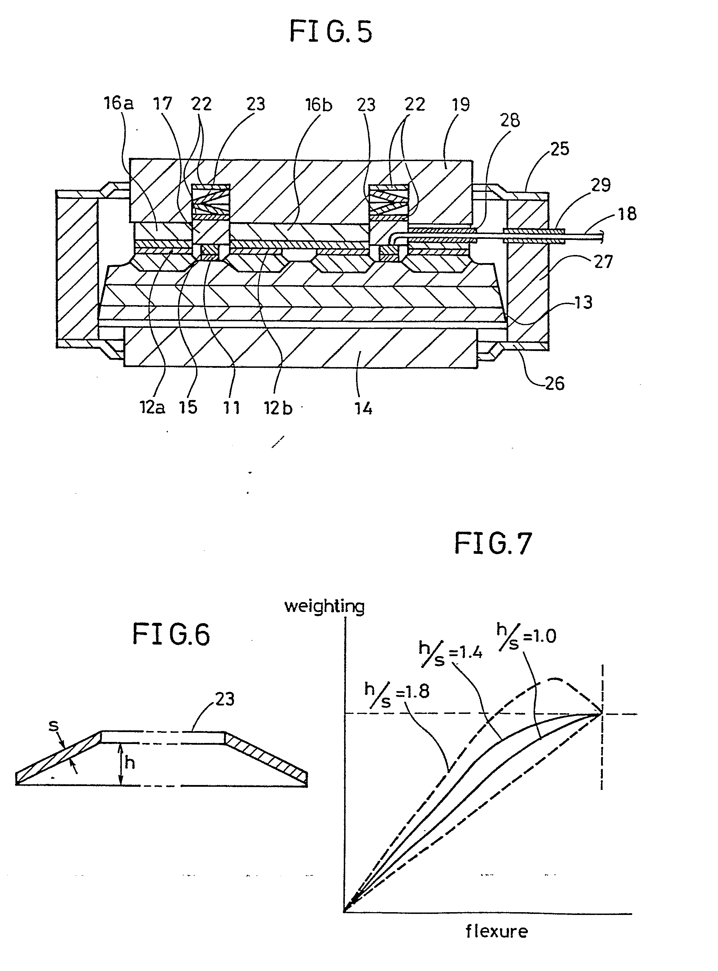

Fig. 5 is a sectional view showing an embodiment of the present invention. The embodiment shown in Fig. 5 is similar to the conventional semiconductor device shown in Fig. 3, except for the points described subsequently. Specifically stated, in a portion of the cathode block 19 opposed to the upper surface of the ceramic ring 17, a concave portion is provided and a coned disc spring 23 made of spring steel is disposed in this concave portion, with steel plain washers 22 being provided in both ends thereof. The coned disc spring 23 pushes the ceramic ring 17 downward so that the gate electrode plate 15 and the gate electrode 11 positioned thereunder are brought into contact with each other by pressure. The plain washers 22 serve to make stable the contact of the coned disc spring 23 with the ceramic ring 17 and with the cathode block 19. In the embodiment shown in Fig. 5, by establishing the characteristic conditions of the coned disc spring 23 as described subsequently, the coned disc spring 23 can make up for the irregularities or tolerance (approximately $\pm 10$ to $100 \mu m$) in the size of the components such as the gate electrode plate 15 and the ceramic ring 17. For utilizing the above described structure, the outgoing lead 18 for gate electrode penetrates the cathode electrode plate 16a to be drawn out to the exterior.

Fig. 6 is a sectional view of a piece of a coned disc spring 23 shown in Fig. 5. In the case of Fig. 5, the spring utilized comprises two pieces of spring symetrically stuck together. It is assumed that the height of the coned disc spring is h and the thickness is s.

Fig. 7 is a diagram of the weighting characteristic curves of the coned disc spring shown in Fig. 6, showing relation between weighting and flexure with a ratio h/s of the height h and the thickness s of the coned disc spring as a parameter. If a coned disc spring is designed to have the weighting characteristic conditions in the range shown by the solid lines (h/s = 1.0 to 1.4), the irregularities in the size dependent on the manufacturing precision of the components can be sufficiently compensated.

If the contact pressure between the gate electrode 11 and the gate electrode plate 15 is too intensive, the ceramic ring 17 might be broken, or the device might be broken by adhesion between the gate electrode 11 and the gate electrode plate 15 due to the conduction in a long period. On the contrary, if the contact pressure is too weak the contact resistance between the gate electrode 11 and the gate electrode plate 15 becomes high, which will cause generation of heat due to the conduction, resulting in the device being broken by thermal fatigue, deterioration of the gate conduction capability and the like. Accordingly, it is important to select an adequate value for the contact pressure. Generally, the contact pressure is preferably 80 to 200 kg per unit area. Since the total contact pressure of the whole device is determined by the area of all the functioning regions, it is necessary to select such a contact area for the gate electrode 11 of the gate electrode plate 15 that the contact pressure between the gate electrode 11 and the gate electrode plate 15 may be a suitable value as described in the foregoing.

Although the embodiment, a GTO was described in the foregoing, the present invention can also be applied to a semiconductor device having a main electrode and a control electrode on one surface of a semiconductor substrate.

Although the present invention has been described and illustrated in detail, it is clearly understood that the same is by way of illustration and example only and is not to be taken by way of limitaion, the spirit and scope of the present invention being limited only by the terms of the appended claims.

WHAT IS CLAIMED IS:

1.   A semiconductor device comprising:

a semiconductor substrate (13) having a surface;

at least one control electrode (11) formed on said surface of said semiconductor substrate (13);

at least one main electrode (12a; 12b) formed on said surface in a manner surrounding said control electrode (11),

a control electrode plate (15) pushed onto said control electrode (11) to be in contact therewith,

an insulating plate (17) fixed on to said control electrode plate (15),

a main electrode plate (16a; 16b) pushed onto said main electrode (12a; 12b) to be in contact therewith,

a conductive block (19) having a concave portion in a surface thereof and positioned on said insulating plate (17) and said main electrode plate (16a; 16b), said concave portion being formed in a corresponding position on either said insulating plate (17) or said main electrode plate (16a; 16b) and the surface excluding said concave portion being pushed onto the other whole surface, and

a spring member (23) provided in said concave portion of said block (19) to push said insulating plate (17) or said main electrode plate (16a; 16b) opposed to said concave portion.

2. A semiconductor device in accordance with claim 1, wherein said control electrode plate (15) comprises a control electrode terminal (18) which penetrats said main electrode plate (16a) to be drawn out to the exterior.

3. A semiconductor device in accordance with claim 1, wherein said main electrode (12a; 12b) comprises a circular first main electrode (12b) and a hollow, circular second main electrode (12a) surrounding said first main electrode (12b) and said control electrode (11) is formed in the form of a ring in a region between said first main electrode (12b) and said second main electrode (12a).

4. A semiconductor device in accordance with claim 1, wherein said spring member (23) has plain washers (22) disposed in both ends thereof.

5. A semiconductor device in accordance with claim 4, wherein said plain washers (22) are made of steel.

6. A semiconductor device in accordance with claim 1, wherein said spring member (23) is a coned disc spring of spring steel.

7. A semiconductor device in accordance with claim 1, wherein said insulating plate (17) is brazed to be fixed onto said control electrode plate (15).

8. A semiconductor device in accordance with claim 1, wherein said semiconductor substrate (13) has pnpn four-layer structure.

9. A semiconductor device in accordance with claim 1, wherein said control electrode (11) and said main electrode (12a; 12b) are formed by aluminum evaporation.

10. A semiconductor device in accordance with claim 1 or claim 7, wherein said control electrode plate (15) is made of silver.

11. A semiconductor device in accordance with claim 1, wherein said insulating plate (17) is made of ceramics.

12.   A semiconductor device in accordance with claim 1 or claim 2, wherein said main electrode plate (16a; 16b) is formed by a copper base and a molybdenum layer.

13.   A semiconductor device in accordance with claim 1, wherein said metallic block (19) is made of copper.

14.   A semiconductor device having a semiconductor component bearing two separate electrodes or groups of electrodes on a common surface, these being associated with each said electrode or group of electrodes one or more electrically conductive or insulating members which are pressed towards the said common surface of the semiconductor component by a common piece,

characterised in that

the common piece presses the said member or members associated with one said electrode or group of electrodes directly or only through substantially non-resilient elements, but presses the said member or members associated with the other said electrode or group of electrodes indirectly through one or more resilient elements.

0158749

## FIG. 1

## FIG. 2

# FIG.3

# FIG.4

# FIG. 5

# FIG. 7

# FIG. 6

## DOCUMENTS CONSIDERED TO BE RELEVANT

| Category | Citation of document with indication where appropriate, of relevant passages | Relevant to claim | CLASSIFICATION OF THE APPLICATION (Int Cl 4) |
|---|---|---|---|
| X | US-A-3 992 717 (RICE)<br><br>* Column 3, line 54 - column 4, line 26 * | 1,2,8, 13,14 | H 01 L 23/48 |
| X | CH-A- 582 425 (WESTINGHOUSE)<br><br>* Column 7, line 47 - column 8, line 1 * | 1,2,9, 12-14 | |
| A | EP-A-0 039 943 (SIEMENS)<br>* Page 9, lines 21-37 * | 3 | |
| A | DE-A-2 644 332 (LICENTIA)<br>* Page 6, last paragraph * | 6,11 | |

TECHNICAL FIELDS SEARCHED (Int. Cl.4)

H 01 L 21/60
H 01 L 23/48

The present search report has been drawn up for all claims

| Place of search | Date of completion of the search | Examiner |
|---|---|---|
| BERLIN | 12-04-1985 | GIBBS C.S. |